Europäisches Patentamt

European Patent Office

Office européen des brevets

(19)

(11) Veröffentlichungsnummer: **0 226 780**
**A1**

(12) **EUROPÄISCHE PATENTANMELDUNG**

(21) Anmeldenummer: **86115426.8**

(22) Anmeldetag: **07.11.86**

(51) Int. Cl.⁴: **G01R 31/32**

(30) Priorität: **09.11.85 DE 3539748**

(43) Veröffentlichungstag der Anmeldung:
**01.07.87 Patentblatt 87/27**

(84) Benannte Vertragsstaaten:
**AT BE CH DE GB LI NL SE**

(71) Anmelder: **Sachsenwerk Aktiengesellschaft**
**Einhauser Strasse 9**
**D-8400 Regensburg(DE)**

(72) Erfinder: **Lutz, Ferdinand, Dr.-Ing.**
**Am Frondweinberg 5a**
**D-6148 Heppenheim(DE)**
Erfinder: **Möller, Klaus, Prof. Dr.-Ing.**
**Im Steinfeld 31**
**D-5100 Aachen-Kornelimünster(DE)**
Erfinder: **Binz, Thomas, Dipl.-Ing.**
**Nussbaumer Strasse 32**
**D-5000 Köln 30(DE)**

(54) **Prüfeinrichtung für Vakuumschaltkammern.**

(57) Die neue Prüfeinrichtung verwendet zur Beurteilung der Funktionsfähigkeit von Vakuumschaltkammern, vorzugsweise wenn diese in gekapselten Schaltanlagen mit einem dielektrisch hochwertigen Isoliermedium eingebaut sind, die Lichtbogenspannung. Dabei wird von einer Energiequelle (E) über einen Draufschalter (D) auf die zu prüfende Vakuumschaltkammer (VA) ein Prüfstrom i gespeist, der so bemessen ist, daß in intakten Schaltkammern ein diffuser Lichtbogen mit verhältnismäßig kleiner Bogenspannung erzeugt wird, während in undichten, z.B. mit Isoliergas gefüllten Kammern Lichtbögen mit deutlich größeren Spannungen entstehen. An den sich öffnenden oder in Offenstellung befindlichen Schaltkontakten (K1, K2) wird die Spannung über ein Zeitintervall Δt durch ein Meßgerät (M) aufgenommen und deren Mittelwert mit der Bogenspannung einer intakten Vakuumschaltkammer verglichen. Das Ergebnis des Vergleichs wird in einem Anzeigegerät (A) erkennbar gemacht und ergibt eine eindeutige Aussage über die Funktionsfähigkeit der geprüften Schaltkammer.

Fig.4

## Prüfeinrichtung für Vakuumschaltkammern

Die Erfindung betrifft eine Prüfeinrichtung gemäß dem Oberbegriff des Patentanspruchs 1.

Solche Prüfeinrichtungen werden zur Kontrolle der Betriebsbereitschaft von Vakuumschaltkammern vor deren Inbetriebnahme, nach langer Betriebsdauer oder nach Störungen benötigt und sind beispielsweise aus der Druckschrift SWV 1.05.22/04.85 über den Vakuumtester VT 60 der Sachsenwerk AG bekannt. Bei dem bekannten Gerät wird zur Überwachung des betriebsmäßig erforderlichen Unterdrucks die innere Durchschlagsspannung bei geöffneten Schaltkontakten bestimmt. Nach den aus dem Gesetz von Paschen bekannten Zusammenhängen zwischen Druck und Durchschlagsspannung wird so festgestellt, ob die geprüften Vakuumschaltkammern noch über ein ausreichendes Vakuum verfügen.

Die bekannten Prüfeinrichtungen arbeiten mit Spannungen von 40 KV und mehr und müssen deshalb mit einem Hochspannungstransformator und einer entsprechend ausgelegten Isolation ausgerüstet sein. Außerdem sind bei den Prüfungen selbst umfangreiche Vorsichtmaßnahmen zu beachten.

Die Arbeitsweise der bekannten Prüfeinrichtungen sieht vor, daß die Vakuumschaltkammern mit einer Prüfspannung getestet werden, die zwischen der Durchschlagspannung bei vollem Vakuum und der Durchschlagspannung von Luft bei atmosphärischem Druck liegt.

Sind Vakuumschaltkammern jedoch in gekapselten Schaltanlagen mit Isoliermedien von größerer dielektrischer Festigkeit als Luft bei Atmosphärendruck, wie z.B. SF-6 Gas oder geeignete Isolierflüssigkeiten eingesetzt, so erreicht die Durchschlagfestigkeit von undichten, mit Isoliermedium gefüllten Kammern Werte, die in derselben Größe wie bei funktionsfähigem Vakuum oder sogar noch höher liegen. Trotz dieser hohen Spannungsfestigkeit besitzen solche Vakuumschaltkammern jedoch kein Schaltvermögen mehr. Eine Überprüfung der Funktionsfähigkeit mit dem bekannten Vakuumtester oder anderen, die Durchschlagfestigkeit erfassenden Prüfeinrichtungen, ist daherfür in Isoliergas oder -flüssigkeit eingebaute Vakuumschaltkammern nicht mehr zur Fehlererkennung ausreichend.

Die Erfindung liegt die Aufgabe zugrunde, eine Prüfeinrichtung zu schaffen, die die Nachteile der bekannten Prüfeinrichtungen vermeidet und mit der somit undichte Vakuumschaltkammern auch dann eindeutig erkannt werden können, wen sie in mit $SF_6$ oder ähnlichen Isoliergasen bzw. Isolierflüssigkeiten gefüllten gekapselten Schaltanlagen eingebaut sind.

Erfindungsgemäß wird dies durch eine Prüfeinrichtung mit den Merkmalen des Anspruchs 1 erreicht.

Dem Erfindungsgedanken liegt die physikalische Erkenntnis zugrunde, daß ein Schaltlichtbogen im intakten Vakuum mit einem Druck von $10^{-4}$ mb oder weniger eine deutlich niedrigere Bogenspannung hat als in Kammern, in denen nach einem temporären Leck durch Gaseintritt ein größerer Druck herrscht oder die sich infolge einer permanenten Leckstelle mit Gas oder Flüssigkeit auffüllen konnten.

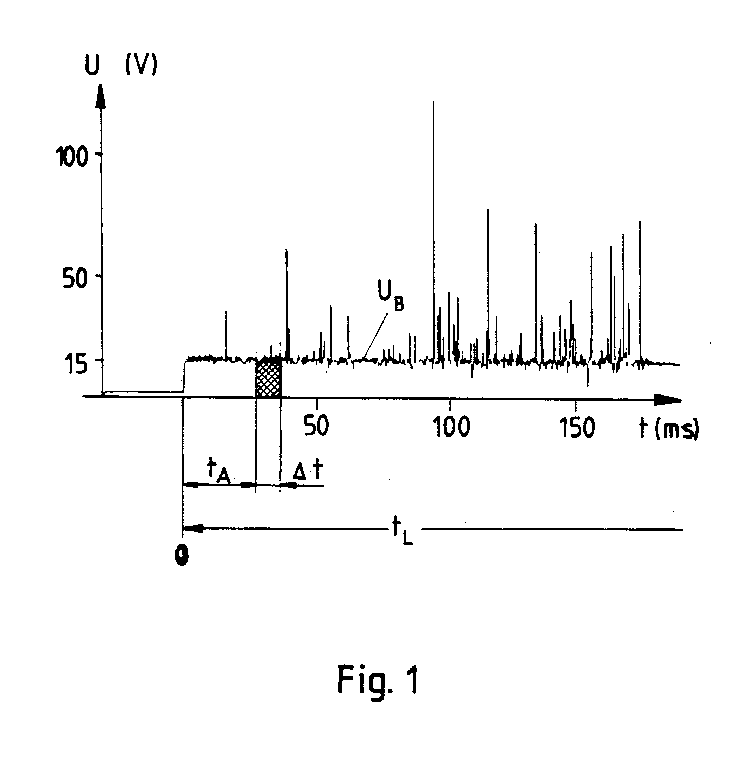

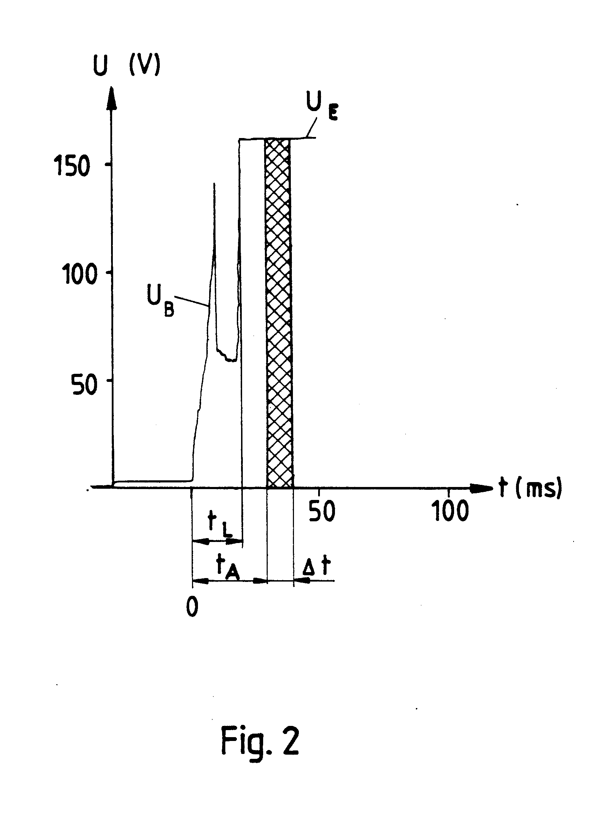

Die der Erfindung zugrunde liegende Idee und ein Ausführungsbeispiel der vorgeschlagenen Prüfeinrichtung werden in den Figuren 1 bis 4 erläutert. In Figur 1 und Figur 2 sind die sich beim Fließen eines abklingenden Gleichstroms ergebenden oszillographischen Verläufe der Lichtbogenspannung $U_B$ in einer funktionsfähigen und im Vergleich dazu in einer undichten, mit einem Isoliergas gefüllten Vakuumschaltkammer dargestellt. Der Prüfstrom ist erfindungsgemäß so gewählt, daß in der funktionsfähigen Schaltkammer nach der Öffnung der Schaltkontakte, also ab dem Zeitpunkt $t = 0$, ein diffuser Lichtbogen mit einer Bogenspannung von etwa 16 V über die gesamte Lichtbogenzeit $t_L$ brennt, die von unregelmäßig verteilten Spannungsspitzen überlagert ist (Fig. 1).

In einer mit Gas gefüllten Schaltkammer, die in demselben Prüfkreis geprüft wird, beobachtet man nach einer Zündspitze mit mehr als 100 V eine Bogenspannung von etwa 60 V. Der Lichtbogen erlischt nun schon nach einer Brenndauer $t_L$ von ungefähr 18 ms, wobei an den Kontakten der Schaltkammer anschließend die Restspannung $U_E$ der Energiequelle angezeigt wird (Fig. 2).

Wegen der größeren Bogenspannung in der gasgefüllten Schaltkammer ist der Prüfstrom i kleiner als bei intakten Vakuumschaltkammern und erlischt mit entsprechend kürzerer Brenndauer $t_L$.

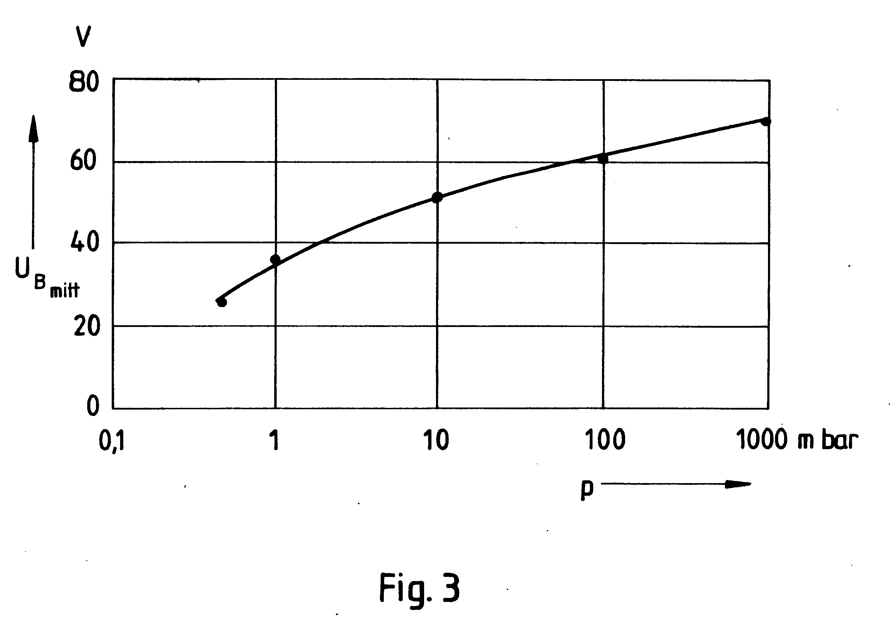

In Figur 3 ist die mittlere Bogenspannung $U_B$ mitt als Funktion des Druckes p in der Schaltkammer dargestellt.

In Figur 1 und Figur 2 ist mit $t_A$ die Zeit markiert, die bis zum Beginn der Spannungsmessung vergeht und mit $\Delta t$ das Zeitintervall, in dem die Spannungsmessung durchgeführt wird. Vorschlagsgemäß sollte $t_a$ kleiner als die gesicherte Lichtbogenzeit funktionsfähiger Vakuumschaltkammern und größer als die gesicherte Lichtbogenzeit von Schaltkammern mit Gaseinbrüchen sein. So wird in dem einen Fall immer die relativ geringe Brennspannung $U_B$ des diffusen Vakuumbogens und im anderen Fall die relativ hohe Restspannung $U_E$ der Energiequelle gemessen. Mit Rücksicht auf die nach Figur 1 im Vakuum auftretenden Spannungsspitzen ist es sinnvoll, die Spannungsmessung über ein Zeitintervall Δt zu integrieren und den Mittelwert festzustellen. Für die praktischenAnwendungen haben sich folgende Werte als vorteilhaft herausgestellt:

$t_A$ = 30 ms

Δt = 10 ms

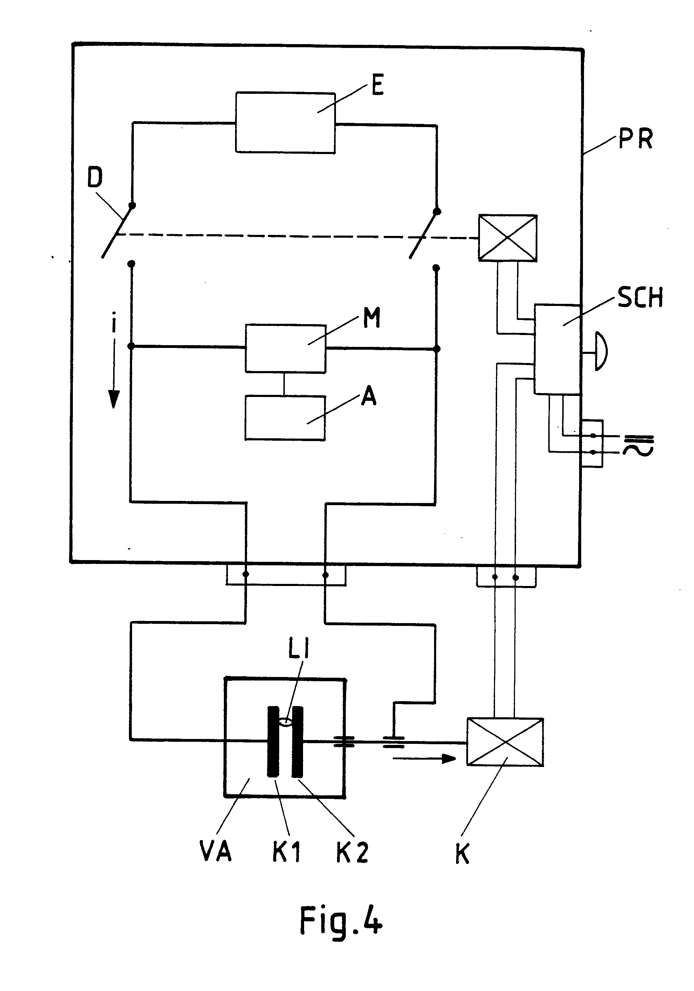

Anhand der in Figur 4 gezeigten schematischen Darstellung wird ein Ausführungsbeispiel der erfindungsgemäßen Prüfeinrichtung und deren Funktionsweise erläutert.

Zur eigentlichen Prüfeinrichtung PR gehört ein elektrischer Energiespeicher E, und ein Draufschalter D, sowie ein Meßgerät M zur Aufnahme der Bogenspannung des Lichtbogens und ein Anzeigegerät A, dessen Signal eine Beurteilung der geprüften Schaltkammer zuläßt.

Die zu prüfende beispielsweise in einer mit SF 6 isolierten, gekapselten Schaltanlage eingebauten Vakuumschaltkammer VA ist an die Prüfeinrichtung PR so angeschlossen, daß über die Schaltkontakte K1 und K2 nach Zuschaltung des Draufschalters ein Prüfstrom fließt und die Bogenspannung $U_B$ gemessen werden kann. Der normalerweise bei jedem Leistungsschalter vorhandene Kraftspeicher K vermittelt die für den Prüfvorgang erforderliche Öffnungsbewegung des Kontaktes K2. Steuerleitungen verbinden den Kraftspeicher K und den Antrieb des Draufschalters D mit einer Spannungsquelle und mit dem Startschalter SCH.

Der Prüfvorgang wird bei betriebsbereitem Energiespeicher E durch die Betätigung des Schalters SCH eingeleitet, wobei die Vakuumschaltkammer VA bei geschlossenen Schaltkontakten K1 und K2 durch die Schließung des Draufschalters D mit dem Prüfstrom i beaufschlagt wird. Gleichzeitig erhält der Kraftspeicher K einen Impuls und trennt kurz danach die Schaltkontakte K1 und K2, wobei der Prüfstrom i nun über den Lichtbogen LI fließt.

Die an den Schaltkontakten abfallende Spannung wird vom Meßgerät M erfaßt und der im Zeitabschnitt Δt ermittelte Mittelwert mit einem eingestellten Festwert, vorschlagsgemäß mit dem Mittelwert der diffusen Bogenspannung von intakten Vakuumschaltkammern, verglichen. Das dabei ermittelte Ergebnis wird im Meßgerät M oder in einem getrennten Anzeigegerät A erkennbar gemacht.

Die Energiequelle E kann nach dem Merkmal des Anspruchs 3 vorteilhaft als Kondensatorbatterie mit einer Ladespannung von 100 V bis 1 KV ausgeführt werden, die jeweils vor Beginn des Prüfvorgangs aufgeladen wird. Ein der Energiequelle E nachgeschalteter Entladewiderstand ist so bemessen, daß der Anfangswert des Stromes etwa 20 A oder mehr und die Entladezeitkonstante mindestens 50 ms beträgt.

Nach den Merkmalen des Anspruchs 5 wird eine Abwandlung der geschilderten Prüfeinrichtung vorgeschlagen, bei der ein energiearmer Hochspannungsimpulsgeber vorgesehen ist, mit dem der Prüfstrom i bei geöffneten Schaltkontakten K1 und K2 gezündet wird. Die Spannungsmessung und die Anzeige des Prüfergebnisses bleiben dabei unbeeinflußt.

Nach dem Merkmal des Anspruchs 11 ergibt sich im Rahmen der Erfindung eine besonders einfache Lösung, bei der zur Beurteilung der Funktionsfähigkeit der Vakuumschaltkammern im Meßgerät M die Lichtbogenzeit $t_L$ aufgenommen und mit der gesicherten Brenndauer des diffusen Lichtbogens in intakten Vakuumschaltkammern verglichen wird.

## Ansprüche

1. Einrichtung zur Prüfung des betriebsmäßig erforderlichen Unterdrucks in Vakuumschaltkammern, die von einem gasförmigen oder flüssigen Isoliermedium, z. B. Luft, $SF_6$ oder Isolieröl umgeben sind, **dadurch gekennzeichnet,** daß eine Energiequelle (E) zur Erzeugung eines Prüfstromes vorgesehen ist, deren Anschlüsse mit der zu prüfenden Vakuumschaltkammer (VA) verbindbar sind, daß die Schaltkontakte (K 1, K 2) der Vakuumschaltkammer (VA) bei fließendem Prüfstrom unter Bildung eines Lichtbogens während der Prüfung geöffnet werden oder sich in der Offenstellung befinden, daß ein Meßgerät (M) die an den Schaltkontakten - ($K_1$, $K_2$) anstehende Spannung oder eine andere vom Spannungsverlauf abhängige Größe aufnimmt und bezüglich der Funktionsfähigkeit der Vakuumschaltkammer (VA) bewertet, und daß ein Anzeigegerät (A) das Prüfergebnis erkennbar macht.

2. Prüfeinrichtung nach Anspruch 1, **dadurch gekennzeichnet,** daß eine Energiequelle (E) mit einer Spannung niedriger als 1 kV vorhanden ist, daß ein Draufschalter (D) zur Verbindung der Energiequelle (E) mit der zu prüfenden Vakuumschaltkammer (VA) vorgesehen ist, und daß auf den Kraftspeicher (K) der zu prüfenden Vakuumschaltkammer (VA) ein Auslöseimpuls zur Öffnung der Schaltkontakte ($K_1$, $K_2$) einwirkt.

3. Prüfeinrichtung nach Anspruch 1 und 2, **dadurch gekennzeichnet ,** daß die Energiequelle (E) aus einer Kondensatorbatterie mit Ladegerät in Verbindung mit einem Entladewiderstand besteht, die so aufeinander abgestimmt sind, daß in intakten Vakuumschaltkammern der Prüfstrom einen diffusen Lichtbogen erzeugt und die Entladezeit mindestens 50 ms beträgt.

4. Prüfeinrichtung nach Anspruch 1 bis 3,
**dadurch gekennzeichnet,**
daß bei arbeitsbereiter Energiequelle (E) der Draufschalter (D) bei geschlossenen Schaltkontakten (K₁, K₂) zuschaltet und kurz danach der Kraftspeicher - (K) die Schaltkontakte (K₁, K₂) öffnet.

5. Prüfeinrichtung nach Anspruch 1 bis 3
**dadurch gekennzeichnet,**
daß bei arbeitsbereiter Energiequelle (E) der Draufschalter (D) bei geöffneten Schaltkontakten (K₁, K₂) zuschaltet und ein zusätzlicher zur Vakuum-schaltkammer (VA) parallel geschalteter leistun-gsarmer Hochspannungsimpulsgeber den Stromfluß einleitet.

6. Prüfeinrichtung nach Anspruch 1 bis 5
**dadurch gekennzeichnet,**
daß das Meßgerät (M) die Spannungsmessung zeitverschoben nach Trennung der Schaltkontakte - (K₁, K₂) bzw. nach Einleitung des Stromflusses durch den Hochspannungsimpulsgeber beginnt, und daß mit einem Integrator in einem Zeitintervall Δt der Mittelwert des gemessenen Spannungsverlaufs gebildet wird.

7. Prüfeinrichtung nach Anspruch 1 bis 6,
**dadurch gekennzeichnet,**
daß im Zeitintervall Δt zwischen den Schaltkontakten (K₁,K₂) von intakten Vakuumschaltkammern die Bogenspannung des diffusen Lichtbogens und bei geschädigten, mit Luft, Isoliergas oder Isolierflüssigkeit gefüllten Schaltkammern der Stromfluß unterbrochen ist und an den Schaltko-ntakten die deutlich größere Restspannung der Energiequelle (E) gemessen wird.

8. Prüfeinrichtung nach Anspruch 1 bis 7,
**dadurch gekennzeichnet,**
daß der im Zeitintervall Δt gebildete Mittelwert der aufgenommenen Spannung mit einem fest eingestellten Spannungswert verglichen und das Ergebnis erkennbar gemacht wird.

9. Prüfeinrichtung nach Anspruch 1 bis 8,
**dadurch gekennzeichnet,**
daß der fest eingestellte Wert der Vergleichsspannung der Bogenspannung von diffus brennenden Lichtbögen entspricht.

10. Prüfeinrichtung nach Anspruch 1 bis 9,
**dadurch gekennzeichnet,**
daß der von der Energiequelle (E) gelieferte Prüfstrom ein konstanter oder abklingender Gleichstrom ist.

11. Prüfeinrichtung nach Anspruch 1,
**dadurch gekennzeichnet,**
daß die Brenndauer des Lichtbogens zur Beurteilung der Funktionsfähigkeit der zu prüfenden Vakuumschaltkammer (VA) verwendet wird.

12. Prüfeinrichtung nach Anspruch 1 bis 11
**dadurch gekennzeichnet,**
daß die Anzeige der Funktionsfähigkeit der geprüften Vakuumschaltkammern mittels optischer oder akustischer Signale erfolgt.

Fig. 1

Fig. 2

Fig. 3

0 226 780

PT 596

Fig.4

Europäisches
Patentamt

**EUROPÄISCHER RECHERCHENBERICHT**

Nummer der Anmeldung

| | | EINSCHLÄGIGE DOKUMENTE | | EP 86115426.8 | |
|---|---|---|---|---|---|
| Kategorie | | Kennzeichnung des Dokuments mit Angabe, soweit erforderlich, der maßgeblichen Teile | Betrifft Anspruch | KLASSIFIKATION DER ANMELDUNG (Int. Cl. 4) | |
| A | | DE - B1 - 2 638 678 (SIEMENS)<br>* Fig. 1 *<br>-- | 1 | G 01 R 31/32 | |
| A | | DE - A1 - 2 931 709 (BBC)<br>* Patentansprüche 1-4 *<br>-- | 1 | | |
| A | | DE - A1 - 3 226 031 (TOKYO SHIBAURA DENKI)<br>* Zusammenfassung *<br>---- | 1 | | |
| | | | | RECHERCHIERTE SACHGEBIETE (Int. Cl. 4) | |
| | | | | G 01 R 31/00 | |
| | | Der vorliegende Recherchenbericht wurde für alle Patentansprüche erstellt. | | | |

| Recherchenort | Abschlußdatum der Recherche | Prüfer |
|---|---|---|
| WIEN | 27-02-1987 | KUNZE |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82